Europäisches Patentamt

**European Patent Office**

**Office européen des brevets**

(11) Publication number: **0 162 516**
**B1**

(12) **EUROPEAN PATENT SPECIFICATION**

(45) Date of publication of patent specification: **08.08.90**

(21) Application number: **85200740.0**

(22) Date of filing: **10.05.85**

(51) Int. Cl.⁵: **H 03 B 19/00,** H 03 K 5/00

(54) **Digital frequency multiplier for high-frequency signals.**

(30) Priority: **18.05.84 NL 8401595**

(43) Date of publication of application:
**27.11.85 Bulletin 85/48**

(45) Publication of the grant of the patent:
**08.08.90 Bulletin 90/32**

(84) Designated Contracting States:
**DE FR GB IT**

(56) References cited:
**US-A-3 418 604**

**IEEE TRANSACTIONS ON MICROWAVE
THEORY AND TECHNIQUES, vol. MTT-29, no. 2,
February 1981, pages 118-122, IEEE, New York,
US; I. SAKAGAMI et al.: "Digital frequency
multipliers using multisection two-strip coupled
line"**

(73) Proprietor: **N.V. Philips' Gloeilampenfabrieken
Groenewoudseweg 1
NL-5621 BA Eindhoven (NL)**

(72) Inventor: **Buijs, Johannes Hendrik
c/o INT. OCTROOIBUREAU B.V. Prof. Holstlaan 6
NL-5656 AA Eindhoven (NL)**

(74) Representative: **Vermeulen, Hermanus Gerardus
Jacobus et al
INTERNATIONAAL OCTROOIBUREAU B.V. Prof.
Holstlaan 6
NL-5656 AA Eindhoven (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The invention relates to a digital frequency multiplier having an input and an output. Said type of multipliers is used in, for example, digital transmission systems having, for example, a transmission rate of 565 Mb/s for converting a clock signal of frequency $f$ into a different clock signal of frequency n.f. This is, for example, necessary at a change from one line code in the transmission system to an other line code. To realise this, it is, for example, possible to multiply the fundamental frequency of the incoming clock signal to the desired frequency of the outgoing signal. It is common practice to effect this multiplication with the aid of active digital circuits. The active digital circuits are integrated on, for example, a semiconductor body together with other portions of the transmission system. The use of active integrated digital circuits increases the total dissipation of the semiconductor body. This may cause designing problems, given the maximum permissible dissipation of the semiconductor body.

The invention has for its object to provide a solution for the above-mentioned problem, and is characterized in that the input is connected *via* a terminating impedance to the input of a short-circuited transmission line having a length λ/4, where λ is the wavelength of the desired output frequency, the input of the short-circuited transmission line being connected to a point of constant potential *via* a first impedance and also to the output *via* a second impedance which is much higher than the terminating impedance, the output being connected to the input of an open-ended transmission line having a length λ/2.

The measures according to the invention achieve that now use is made of passive components to effect the desired multiplication. As a result thereof the dissipation added by the multipliers which are operative in the system to the overall dissipation of the system is substantially nill.

"It should be noted that from IEEE Transactions on Microwave Theory and Techniques, Vol. MTT 29, No. 2, February 1981, pages 118—222, a digital frequency multiplier is known, where in use is made of passive components to effect the desired multiplication. It consists of cascaded sections of uniform loss-less commensurate coupled transmission lines and three resistors in π structure. The arrangement and the indivudual length of the transmission lines however differ from the claimed multiplier and through this the operation is also different.

Further is from the U.S. Patent Specification 3,418,604 a high frequency phase synchronized signal synthesizer known, wherein additional doublings of the number of cycles of energy present on a transmission line is obtained by connecting to it in sequence reflective sub-line having one-half the impedance of the line and having lengths such that the transit times in the stubs are equal to the line width of the total number of cycles on the line at the respective point at which the stub is to be connected. Through this a uniform wave train of high frequency energy having a definite number of cycles is generated. Configuration and operation differ with the claimed multipier."

The invention will now be described in greater detail by way of example with reference to the accompanying drawing.

Fig. 1 shows a first embodiment of a frequency multiplier according to the invention, wherein n=3.

Fig. 2 shows a time diagram to explain the operation of the frequency multiplier according to the invention.

Fig. 3 shows a second embodiment of a frequency multiplier according to the invention, where n=2.

Fig. 4 shows a time diagram to explain the operation of the frequency multiplier of Fig. 3.

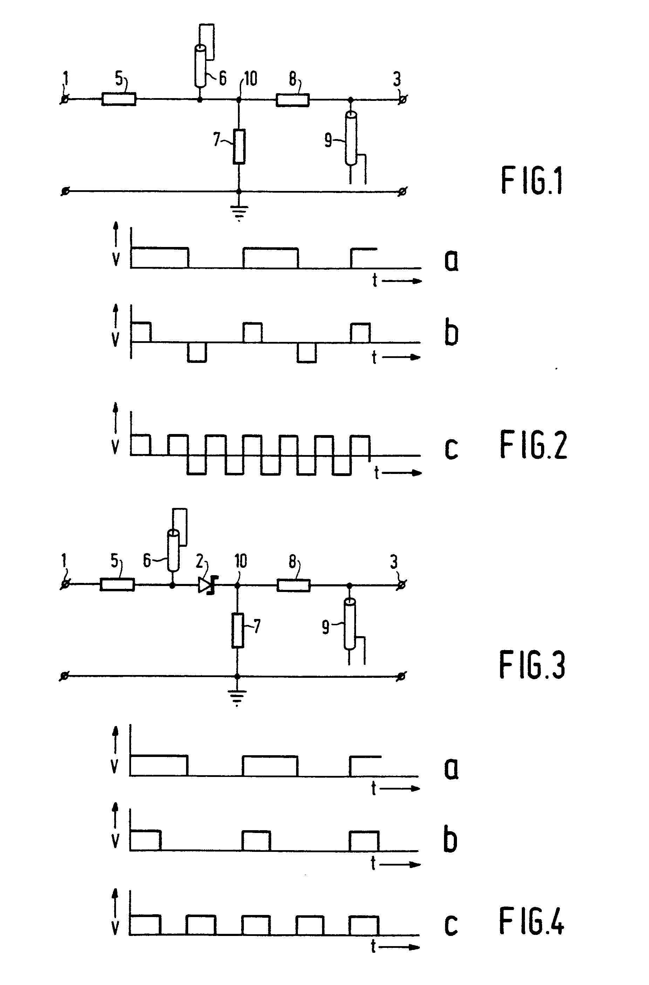

In the multiplier shown in Fig. 1, reference numeral 1 denotes the input terminal to which the input siganl to be multiplied is applied. The input 1 is connected to the input of a short-circuited transmission line 6 *via* a terminating impedance 5. The input of the short-circuited transmission line 6 is connected to ground *via* the impedance 7 and also to the output 3 of the multiplier *via* the impedance 8. The output 3 of the multiplier is connected to the input of an open-ended transmission line 9. The value of the impedance 7 is preferably chosen to be equal to the value of the terminating impedance 5. The value of the impedance 8 must be chosen to be much higher than the values of the impedances 5 and 7, to provide that the transmission line 9 is open at both ends and can act as a resonator. The length of the transmission line 6 is equal to λ/4, wherein λ is the wavelength of the desired output frequency. The length of the transmission line 9 is equal to λ/2.

The input signal applied to the input 1 of the multiplier has the shape as shown, for example, in Fig. 2a. This input signal is differentiated with the aid of the short-circuited transmission line 6. This results at point 10 of the multiplier in a signal having approximately the shape as shown in Fig. 2b. If this signal is now applied to the transmission line 9, which is open at both ends, then the transmission line acts as a resonator resonating at the frequency having the wavelength λ. The output signal at the output 3 of the multiplier has the shape as shown in Fig. 2c. Comparing Figs. 2a and 2c shows that the input frequency has been multiplied by a factor of 3.

If it is desired that the multiplying factor n is even, for example n=2, then the negative or the positive pulses must be removed after the short-circuited transmission line 6. This can, for example, be realized in a manner as shown in Fig. 3. A diode, for example a Schottky diode, is arranged between the input of the short-circuited transmission line 6 and the junction 10 of the impedances 7 and 8. The input signal remaining as shown in Fig. 2a, the signal occurring at point 10 has a shape as shown in Fig. 4b. The output signal at the output 3 of the multiplier now has a shape as shown in Fig. 4c. Comparing Figs. 4a and 4c shows that the output signal has now been multiplied by a factor of 2.

Depending on the frequency range in which the digital transmission system operates, the transmission lines 6 and 9 can be realized with the aid of printed conductors, cables, microstrips etc.

## Claims

1. A digital frequency multiplier for high frequencies having an input and an output, characterized in that the input is connected *via* a terminating impedance to the input of a short-circuited transmission line having a length λ/4, where λ is the wavelength of the desired output frequency, the input of the short-circuited transmission line being connected to a point of constant potential *via* a first impedance and also to the output *via* a second impedance which is much higher than the terminating impedance, the output being connected to the input of an open-ended transmission line having a length λ/2.

2. A digital frequency multiplier as claimed in Claim 1, characterized in that the input of the short-circuited transmission line is connected to the junction of the first and second impedances *via* a diode.

3. A digital frequency multiplier as claimed in Claim 2, characterized in that the diode is a Schottky diode.

## Patentansprüche

1. Digitaler Frequenzmultiplizierer für Hochfrequenzsignale mit einem Eingang und einem Ausgang, dadurch gekennzeichnet, daß der Eingang über eine Abschlußimpdanz mit dem Eingang einer kurzgeschlossenen Übertragungsleitung mit einer Länge λ/4 verbunden ist, wobei λ die Wellenlänge der erwünschten Ausgangsfrequenz ist, wobei der Eingang der kurzgeschlossenen Übertragungsleitung über eine erste Imepdanz mit einem Punkt konstanten Potentials und ebenfalls über eine zweite Impedanz mit dem Ausgang verbunden ist, wobei diese zweite Impedanz viel höher ist als die Abschlußimpedanz, wobei der Ausgang mit dem Eingang einer offenen Übertragungsleitung mit einer Länge λ/2 verbunden ist.

2. Digitaler Frequenzmultiplizierer nach Anspruch 1, dadurch gekennzeichnet, daß der Eingang der kurzgeschlossenen Übertragungsleitung über eine Diode mit dem Knotenpunkt der ersten und zweiten Impedanz verbunden ist.

3. Digitaler Frequenzmultiplizierer nach Anspruch 2, dadurch gekennzeichnet, daß die Diode eine Schottky-Diode ist.

## Revendications

1. Multiplicateur de fréquence numérique pour de hautes fréquences comportant une entrée et une sortie, caractérisé en ce que l'entrée est connectée, par l'intermédiaire d'une impédance de terminaison, à l'entrée d'une ligne de transmission court-circuitée ayant une longueur λ/4, où λ est la longueur d'onde de la fréquence de sortie souhaitée, l'entrée de la ligne de transmission court-circuitée étant connectée à un point de potentiel constant par l'intermédiaire d'une première impédance et à la sortie par l'intermédiaire d'une seconde impédance qui est nettement plus élevée que l'impédance de terminaison, la sortie étant connectée à l'entrée d'une ligne de transmission ouverte d'une longueur λ/2.

2. Multiplicateur de fréquence numérique suivant la revendication 1, caractérisé en ce que l'entrée de la ligne de transmission court-circuitée est connectée à la jonction de la première et de la seconde impédance par l'intermédiaire d'une diode.

3. Multiplicateur de fréquence numérique suivant la revendication 2, caractérisé en ce que la diode est une diode Schottky.

EP 0 162 516 B1

FIG.1

FIG.2

FIG.3

FIG.4

1